# EUROPEAN PATENT APPLICATION

(11) **EP 2 600 531 A1**
(43) Date of publication of application: **05.06.2013**
(21) Application number: 11306596.5
(22) Date of filing: 01.12.2011
(51) Int. Cl.: H03M 7/40, H03M 7/42, G06T 1/00

(54) **Method for determining a modifiable element in a coded bit-stream and associated device**

(71) Applicant: Thomson Licensing, 92130 Issy-les-Moulineaux (FR)
(72) Inventor: Robert, Antoine, 35576 Cesson-Sevigne (FR); Baudry, Severine, 35576 Cesson-Sevigne (FR); Lefebvre, Frederic, 35576 Cesson-Sevigne (FR)
(74) Representative: Huchet, Anne

(57) **Abstract**

The invention relates to a method for determining a modifiable element in a coded bit-stream (Cₒ). The method comprises a step of decoding (E200) a part of the coded bit-stream (Cₒ); a step of modifying (E201) said part of the coded bit-stream (Cₒ); a step of decoding (E202) the modified part of the coded bit-stream (Cₘ); a step of verifying (E203) whether the modified part of the coded bit-stream (Cₘ) is compliant with the coded bit-stream (Cₒ); a step of verifying (E203) whether an element (EIₘ) in the decoded modified bit-stream, called modifiable element, is different from an element (EI) in the decoded original bit-stream.

The invention also relates to a device for determining a modifiable element in a coded bit-stream.

## Description

### Field of the invention

The invention relates to a method for determining a modifiable element in a coded bit-stream without modifying the compliance of the intended bit-stream and associated device.

### Background of the invention

Among many alternative copyrights management systems, watermarking techniques hide binary information into multimedia content in a robust and imperceptible manner. The embedded information can be used later during forensics analysis to identify the source of an illegal copy. In this context, various types of data can be watermarked, including compressed video bit-stream. Early approaches decompressed the stream, applied the watermarking in the pixel domain, and then recompressed. An early advance was to use information from the original compressed stream to simplify the recompression. This was improved with techniques that partially decompress the stream by applying entropy decoding and parsing of the coded bit-stream. After entropy decoding, the watermarking algorithms worked directly on elements such as coefficients or motion vectors. After the stream was modified to represent the watermark data, the entropy coding was applied.

The document WO 2008/118145 describes a method for modifying an entropy coded bit-stream. The method comprises some partial decoding and re-encoding stages to determine potentially modifiable parts of coded bit-streams adapted to carry watermark information. In case of H.264 video stream, the method comprises searching for modifiable CABAC syntax elements. In a variant, the method comprises searching for modifiable motion vector differences of some blocks of Inter predicted images that use CABAC bypass encoding mode. The coded bit-stream is partially decoded until finding the acceptable syntax elements. Modified syntax elements are then CABAC re-encoded to select those which do not modify the compliance of the bit-stream.

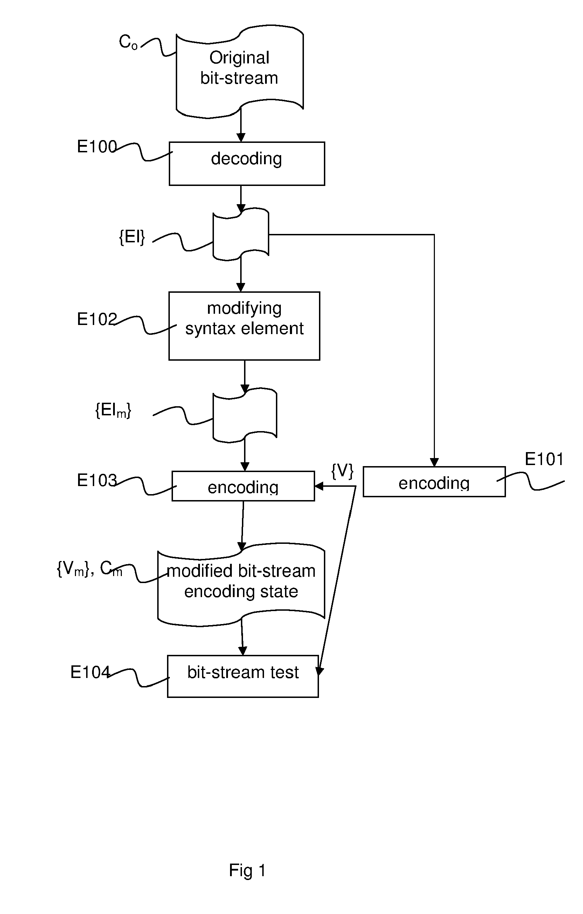

**Figure 1** represents the method for determining a modifiable element in a coded bit-stream while keeping the compliance of the bit-stream according to prior art. Given a CABAC encoded H.264/AVC bit-stream Cₒ, a first step E100 comprises building a mapping of the target element EI to the original coded block by decoding the bit-stream Cₒ. In a step E101, this syntax element EI is then processed by an instrumented CABAC encoder to restore the original compressed bit-stream. The restored bit-stream, identical to original bit-stream Cₒ is not of interest here, but rather it is the instrumentation V of the CABAC encoder that is useful through encoding state variable values and the context variable values. The instrumented CABAC encoder can be used to track the correspondence between syntax elements. In a step E102, one or more acceptable alternative values for the target element EIₘ are determined. Each possible alternative syntax value will be binarized to an alternative bin string. The reader not familiar with CABAC should know that binarization maps all non-binary valued syntax elements into bin sequences called bin strings. In step E103, each alternative bin string is CABAC encoded to yield the alternative coded block of bit-stream Cₘ. In the CABAC coding process, the alternative bin string modifies the state variables and the affected context variables from their original values V to their alternative values Vₘ. In a final step E104, the bit-stream is tested: If the values Vₘ of the last alternative state variables and affected context variables are identical to the values V of the last state variables and the affected context variables resulting from the encoding of the original content, the possible alternative syntax value EIₘ is called an "acceptable alternative value". In other words, the modification would be acceptable if the state variables and the affected context variables have the same values that they would have had if the modification had not been made. Thus a "modifiable element" is an element in the coded bit-stream for which an acceptable alternative value has been found. A modifiable element is associated to a set comprising original value and at least an alternative value of the coded bit-stream.

Known method for modifying a coded bit-stream needs at least partial decoding and re-encoding steps. Thus known method raises the issue of being constrained by the encoding, which is highly restrictive in term of acceptable alternative value for the elements (for instance bit length constraints). Furthermore known method for modifying coded bit-stream is slow. A more efficient and fastest method for modifying coded bit-stream is therefore needed.

### Summary of the invention

The purpose of the invention is to overcome at least one of the disadvantages of prior art by proposing a method for determining a modifiable element in a coded bit-stream without any encoding step. The idea of the invention is to compare the entropy decoding states rather than the entropy encoding ones for determining acceptable alternative value for the elements. Therefore, the search for modifiable element is advantageously faster and driven by the decoding state variables which are more flexible than the encoding ones allowing a more efficient search.

To this end, the invention relates to a method for determining a modifiable element in a coded bit-stream remarkable in that the method comprises a step of decoding a part of the coded bit-stream; a step of modifying the part of the coded bit-stream; a step of decoding the modified part of the coded bit-stream; a step of verifying whether the modified part of the coded bit-stream is compliant with the coded bit-stream; a step of verifying whether an element in the decoded modified bit-stream, called modifiable element, is different from an element in the decoded original bit-stream.

The invention is advantageously much faster than the anterior work since it only comprises steps for decoding the bit-stream. Besides the method according to the invention advantageously implies an improved efficiency in term of number of modifiable elements since it is constrained by the decoding process.

Finally, an advantageous native feature is to avoid modifying the length of the bit-stream.

According to a particularly advantageous characteristic of the invention, the step of decoding the part of the bit-stream result in a first set of decoded elements; the step of decoding the modified part of the coded bit-stream result in a second set of decoded elements; and the step of verifying whether an element in the modified bit-stream, called modifiable element, is different from an element in the bit-stream comprises verifying whether the last modified decoded element, called modifiable element, among the second set of decoded elements is different from the last decoded element among the first set of decoded elements and whether other decoded elements among the second set of decoded elements and other decoded elements among the first set of decoded elements are identical.

According to a particularly advantageous characteristic of the invention, the step of decoding the part of the bit-stream result in a first set of decoding variable states; the step of decoding the modified part of the coded bit-stream result in a second set of decoding variable states; and the step of verifying whether the modified part of the bit-stream is compliant with the bit-stream comprises verifying whether the last decoding variable states among the second set of decoding variable states is identical to the last decoding variable states among the first set of decoding variable states.

According to a characteristic of the invention, the step of modifying a part of the coded bit-stream further comprises determining a value among all possible binary values of same length as the length of the part of the coded bit-stream. In a variant, the step of modifying the part of the coded bit-stream further comprises determining a value among binary values comprised in a range around the binary value of the part of the coded bit-stream. In another variant, the step of modifying the part of the coded bit-stream further comprises determining a value among values comprised in a table.

According to a particularly advantageous characteristic of the invention, the bit-stream is a CABAC coded bit-stream and an element is a syntax element. According to another particularly advantageous characteristic of the invention, the bit-stream is a CAVLC coded bit-stream and an element is a syntax element. According to another particularly advantageous characteristic of the invention, the bit-stream is a VLC coded bit-stream and an element is a syntax element.

According to a particularly advantageous characteristic of the invention, the step of decoding the modified part of the coded bit-stream; the step of verifying whether the modified part of the coded bit-stream is compliant with the coded bit-stream; and the step of verifying whether an element in the decoded modified bit-stream, called modifiable element, is different from an element in the decoded original bit-stream; are iteratively repeated for each modified part of the coded bit-stream resulting from the step of modifying the part of the coded bit-stream.

According to another characteristic, the modifiable element is adapted to carry watermark information.

According to another aspect, the invention also relates to a device for determining a modifiable element in a coded bit-stream. The device comprises means for decoding a part of the coded bit-stream; means for modifying the part of the coded bit-stream; means for decoding the modified part of the coded bit-stream; means for verifying whether the modified part of the coded bit-stream is compliant with the coded bit-stream; means for verifying whether an element in the decoded modified bit-stream, called modifiable element, is different from an element in the decoded original bit-stream. The device can comprise means to implement any other characteristics, taken separately or in combination, previously presented for the method.

### Brief description of the drawings

Other characteristics and advantages of the invention will appear through the description of a non-limiting embodiment of the invention, which will be illustrated, with the help of the enclosed drawings.
- **Figure 1** represents the method for modifying a compressed bit-stream according to prior art;
- **Figure 2** represents the method for determining a modifiable element in a coded bit-stream according to variant embodiments,
- **Figure 3** represents the correspondence between bin string and decoding variables in CABAC format,
- **Figure 4** illustrates a device for determining a modifiable element in a coded bit-stream according to a particular embodiment.

### Detailed description of preferred embodiments

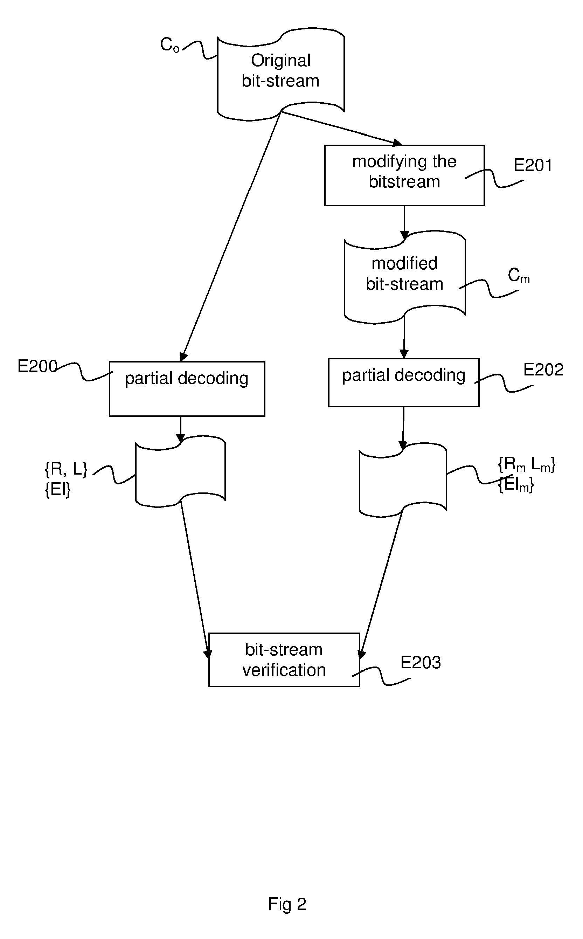

**Figure 2** represents the method for determining a modifiable element in a coded bit-stream according to variant embodiments.

The first embodiment modifies encoded bit-stream directly without requiring entropy re-encoding steps. Further, the first embodiment is provided in which the entropy coder uses a variable or a fixed length coding scheme, more specifically VC1 (i.e. WMV9) or MPEG-2/MPEG-4 standards. The skilled in the art will appreciate that the description of the first embodiment is compatible with Context Adaptive Variable Length Coding (CAVLC) used in the H.264/AVC standard.

Modifying a VC1 stream involves changing a coded element in the VC1 stream, such as coefficients, motion vector differences. In a variable or fixed length coding scheme, each element corresponds to a determined number of bits in the bit-stream wherein the number of bits depends on the element. Reciprocally, a part of the bit-stream corresponds after decoding to an element and to a decoding variable state.

An original bit-stream Cₒ representative of a compressed audio/video content according to VC1 (i.e. WMV9) format is processed.

In a preliminary step, not represented on figure 2, a position in the bit-stream is determined from which the steps of the method according to the invention is applied. Such positions can be viewed as markers in the bit-stream identifying each element. Indeed, each determined positions in the bit-stream represents a possibly modifiable element to be checked by the invention. In the following, the terms "part of the bit-stream" or "bit-stream" are interchangeably used.

In a step E200, the original bit-stream Cₒ, more precisely the part of bit-stream Cₒ starting at the determined position, is decoded to get the element EI and corresponding state variables.

In a step E201, the original bit-stream is directly modified while the possible impact of the bit-stream modification on the element is measured after decoding. Advantageously, the modification of the bit-stream is guided by look-up tables of coded elements. Theoretically, the bit-stream (or the part of the bit-stream) of length N could be modified to any binary value of length N, i.e. from (0)_{N} to (1)_{N}. As the elements are coded through look-up tables and since the modified bit-stream has to remain compliant with the specific compression standard, only the values of the bit-stream comprised in the look-up tables are processed. Thus, a reduced set of values compared to an exhaustive enumeration of all possible binary values for the bit-stream are decoded and verified. The number of iterations of the steps E202 and E203 of the method dependant of the number of modified bit-streams Cₘ to process is advantageously reduced.

In a step E202, the modified bit-stream Cₘ is decoded to get the element EIₘ, one element for each modified bit-stream. The decoding step E202 is applied to each modified bit-stream Cₘ, thus the plurality of modified bit-stream Cₘ advantageously generates directly the so-called possible alternative elements EIₘ. The alternative elements EIₘ are temporary saved. Besides, the alternative decoder state variables are temporary saved.

In a step E203, each modified bit-stream Cₘ is tested. Indeed, the modified compressed bit-stream has to be compatible with the decoding of the rest of bit-stream and has to provide modified elements. To that end, the alternative elements and the original one are successively compared up to find all different elements thus corresponding to possible alternative elements. The test further comprises comparing the original decoding state variables and the alternative decoding state variables. The decoding of original bit-stream and the decoding of the modified bit-stream start from same state variables and have to end into identical state variables. Thus each modified bit-stream which satisfies both tests is candidate for carrying modifiable elements.

In a final optional step, a final selection is applied to set of modified bit-streams, complying with both tests, and to their corresponding alternative elements according to criteria specific to a given application. Such application is for instance watermarking as latter described in the second embodiment.

Step E200 in one hand and steps E201, E202, E203 in the other hand are simultaneously or successively processed in any order according to various embodiments. Besides, step E201 in one hand and step E202 followed by step E203 in the other hand are simultaneously or iteratively processed for each modified bit-stream.

The second embodiment also modifies encoded bit-stream directly without requiring entropy re-encode steps. Further, the second embodiment is provided in which the entropy coder uses an arithmetic code and, more specifically, in which the arithmetic coding scheme known as Context-based Adaptive Binary Arithmetic Coding (CABAC) is used. CABAC can be characterized as a coding scheme with "memory" in that subsequent coded sequences depend on previous coded sequences. Thus, a given coded sequence is modified in such a way that subsequent coded sequences can still be correctly decoded. CABAC is widely used in the H.264/AVC standard.

Modifying a CABAC stream involves changing a coded syntax element in the CABAC stream. However, as mentioned above, it is desirable to apply a watermark by modifying a coded syntax element of a CABAC bit-stream without changing the decoding of any other syntax elements. This is difficult because the value of each element in a CABAC stream affects the interpretation of the values that follow. In general, changing a coded syntax element will cause all future coded elements to be misinterpreted or non-decodable by the decoder.

Some applications have an additional constraint that the changes made to an encoded bit-stream cannot modify the length of the bit-stream. At the extreme, it is required that a coded element be replaced with an alternative value only if the bit length of the alternative value is the same as that of the original value.

The term "Decoding Variables" used above refers to two sets of variables. The first set is called "Context Variables" which contains two variables which represent the probability of a symbol 0 or 1 (represented by the identification of which of these symbols is least probable, LPS, and a probability state index, I, into a table of probabilities indicating the probability of this LPS appearing next in the bit-stream). Each context is associated with a context index which maintains a set of context variables since each type of syntax element is associated with a particular context. The second set is called "State Variables" which is composed of two variables in order to define the internal CABAC range value (represented by the offset of the range, L, and the width of the range, R). The L and R variables are shared among all syntax elements while separate LPS and I values are maintained for each context. The terms "state variables", "state value(s)", and "state variable values" are interchangeably used herein.

The term "syntax elements" used above refers to any element that is encoded as specified in the H.264/AVC, among which coefficients, motion vector differences.

The term "decoding" here should be understood as "partial decoding" or not yielding to the fully decoded images but to intermediary decoding state. In the second embodiment, the term "decoding", "entropy decoding" or "CABAC decoding" are interchangeably used herein.

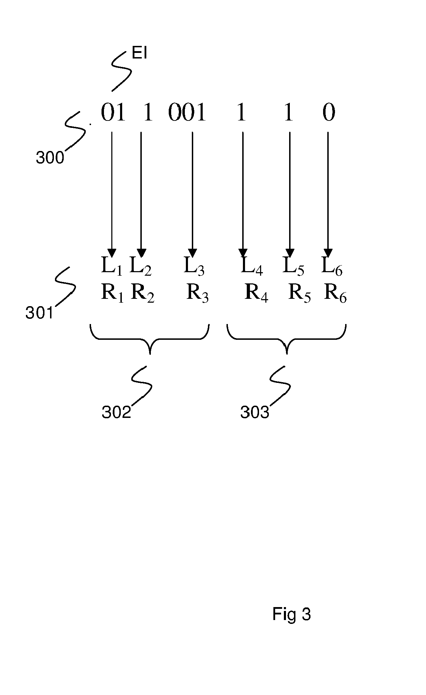

The second embodiment describes a variant in which the CABAC bypass mode is exploited to improve the efficiency of the search for modifiable elements for the coded bit-stream and simplify the reader comprehension. The CABAC bypass mode is a special case in which the two symbols 0 and 1 have equal probability, no context is used and the probability of both symbols is fixed to be 0.5. As the skilled in the art of video compression standards, the H.264 standard specifies three syntax elements that can use the CABAC bypass mode. These are the sign of coefficients, the suffix of motion vector differences, and the suffix of coefficient data. For these, only state variables are modified during the decoding. The L value, representing the offset of the range, and the R value, representing the width of the range, change as bits are decoded. Thus, the likelihood of finding alternative syntax values that yield the same decoding state variable values as the original is higher with bypass mode syntax elements. For the reader not familiar with CABAC, figure 3 represents the correspondence between bin string 300 and decoding states 301 in CABAC format. Each non-binary syntax element EI is binarized into a bin string 300. In CABAC decoding section 302, a new decoding state is reached after the decoding of a variable number of bits from the bin string 300, i.e. 2 bits, 1 bit and 3 bits on the example of figure 3. In bypass mode 303, a new decoding state is reached after the decoding of each bit.

In the second embodiment, only the suffix of motion vector differences syntax elements is considered. For each of these, we search for alternative values that do not affect the values of any other syntax elements and yield the same state value in the CABAC decoder after its corresponding bin string is processed. From these, we select a subset to be used for embedding as described above.

An original bit-stream Cₒ representative of a compressed audio/video content is processed. According to variant embodiments, the bit-stream consists of encoded video in H.264 format.

In a preliminary step, not represented on figure 2, a position in the bit-stream is determined from which the steps of the method according to the invention is applied. Such positions can be viewed as markers in the bit-stream identifying each element. Indeed, each determined positions in the bit-stream represents a possibly modifiable element to be checked by the invention. In the following, "part of the bit-stream" or "bit-stream" is interchangeably used.

In a step E200, the original bit-stream Cₒ, indeed the part of bit-stream Cₒ starting at few positions before the determined position, is decoded until the syntax elements EI and all the CABAC state variables L, R are temporary saved. Here it is some CABAC local variables as the offset of the range L and width of the range R which are less restrictive than in a CABAC encoder (range offset L, range width R and the most restrictive the impacted bits of the bit-stream). The set of original bit-steam decoding state variables {L, R} advantageously allow starting the decoding of the part of the modified bit-stream from any state in the decoder, and verifying the variable state of the modified bit-stream decoding for any value.

In a step E201, the original bit-stream is directly modified while the possible impact of the bit-stream modification on the syntax elements is measured after CABAC decoding. As the compressed bit-stream is directly modified, an advantageous native feature of the method is to not modify the length of the bit-stream. In a variant, only few values among all possible binary values for the bit-stream are advantageously processed. Theoretically, the bit-stream (or the part of it) of length N could be modified to any binary value of length N, i.e. from (0)_{N} to (1)_{N}. Since the modified bit-stream has to remain compliant with the specific compression standard, only few values comprised in a range around the original bit-stream value result in successful test in step E203. Thus the bit-stream value is decreased from the original value down to a lower value for which the decoding of the bit-stream results in a different decoding state and the bit-stream value is increased from the original value up to an upper value for which the decoding state of the bit-stream is also different from the previous one. In a variant, the bit-stream is decreased from the original value down to a lower threshold and the bit-stream is increased from the original value up to an upper threshold. The thresholds are for instance set so as to limit the number of iterations of the modified bit-stream test. The number of iterations of the steps 202 and 203 of the method is dependant on the range in which bit-streams are modified and is advantageously reduced for this variant compared to exhaustive modified bit-stream test.

In a step E202, the modified bit-stream Cₘ is CABAC decoded until the syntax elements EIₘ. The decoding step E202 applied to the modified bit-stream Cₘ advantageously generates directly the so-called possible alternative syntax elements. The alternative syntax elements EIₘ are temporary saved. Besides, some alternative decoding CABAC state variables Lₘ, Rₘ are temporary saved. Advantageously, a set {EIₘ} comprising successive values of syntax elements is collected due to the latency of the CABAC scheme in the second embodiment. Indeed, an alteration of a bit in the coded bit-stream may impact the syntax element with an extendable latency in CABAC. In contrast, according to the first embodiment or to an embodiment where the bit-stream is a VC1 or MPEG2 bit-stream, there is no variable latency between the decoding of the modified bit-stream and the impact of the modification on the decoded alternative element. A set comprising successive values of decoding state variables {Lₘ, Rₘ} is further collected. Advantageously, only the starting decoding state (Lₘ, Rₘ) variable and the final decoding state variable (Lₘ, Rₘ), i.e. decoding state variables after the decoding of a modified syntax element are collected for the modified bit-stream.

Step E200 in one hand and step E201 followed by step E202 in the other hand are simultaneously or successively processed in any order according to various embodiments. Besides, step E201 in one hand and step E202 followed by step E203 in the other hand are simultaneously or iteratively processed for each modified bit-stream.

In a step E203, the modified bit-stream Cₘ is tested. Indeed, the modified compressed bit-stream has to comply with the following requirements: Firstly the modified bit-stream has to remain compliant with the specific compression standard; secondly the alternative syntax element, result of the decoding of the modified bit-stream, has to be different from the original syntax element. Besides, in case of watermarking application, the video sequence resulting from the full decoding of the bit-stream must comply with general watermarking constraint: the modified sequence is perceptually indistinguishable but results in a measurable image (in term of blocks and neighbours) changes hiding the watermark information. This general watermark requirement remains unchanged from the prior art watermarking method and will not be described here. Besides according to the application, different constraints may apply. We will focus on the first and second requirements. Thus the test comprises a checking of syntax element modification. To that end, the test comprises comparing the original decoded syntax element and the alternative syntax element. Advantageously, the elements of the set of alternative syntax elements and of the set of original syntax elements are successively compared up to find a first different syntax element. The test further comprises a compliance checking to ensure the decoding of the rest of the bit-stream. To that end, the test comprises comparing the original decoding CABAC states and the alternative decoding CABAC states. The decoding of original bit-stream and the decoding of the modified bit-stream start from a same CABAC state and finish into an identical CABAC state. However, some states in the range between start state and finish state are different, thus producing a modified syntax element. Indeed, alternative CABAC decoding state corresponding to the decoding state where a modified syntax element is observed is compared with original CABAC state to check whether an identical CABAC state is observed. Advantageously, in bypass mode, only range width and range offset are checked among the decoding state variables. On the contrary, known prior art method requires comparing, at the encoding step, at least range width, range offset and bit-length. Advantageously, at least a state variable less (bit-length) is checked regarding prior art. Besides the bit-length variable is a selective constraint for syntax elements. Thus corresponding CABAC activities are compared to original ones to select alternative syntax element that do not modify the decoding except a precise syntax element: a modifiable syntax element.

In an optional step, the modified bit-stream, complying with both first and second requirements, and the corresponding alternative syntax elements are selected as adapted to carry watermark data provided that, the modification is measurable but perceptually indistinguishable. Any known method for selecting watermark among modifiable elements not modifying the compliance of the modified bit-stream is compatible with the invention.

According to a variant, when there exist a plurality of modifiable elements for a part of the bit-stream, only one modifiable element is kept. For instance the first modifiable element found is kept thus optimizing the speed of the method since the search for other modifiable elements for that part of the bit-stream could be bypassed. In another variant, the modifiable element that best matches for the application is kept, for instance it could be a criteria combining visibility and robustness of the watermarking.

As the method is based on modifying the compressed bit-stream without any encoding stage, the access to the original uncompressed bit-stream is advantageously not required by the watermarking process.

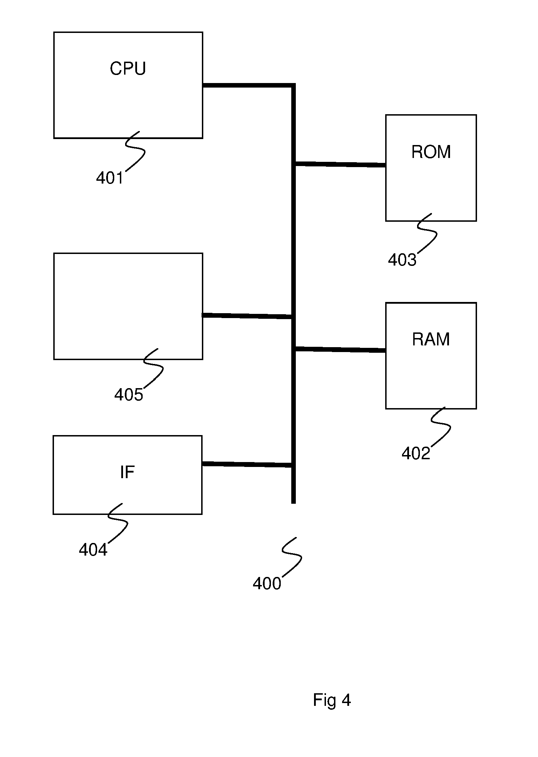

**Figure 4** illustrates a device for determining a modifiable element in a coded bit-stream according to a particular embodiment. The device is, for instance, a computer at content provider or service provider. The device is, in a variant, any device intended to process original compressed bit-stream. The device 400 comprises physical means intended to implement an embodiment of the invention, for instance a processor 401 (CPU), a data memory 402 (RAM, HDD), a program memory 403 (ROM) and a decoder 405 for decoding compressed bit-stream. The decoder 405 comprises means to decode a part of the coded bit-stream Cₒ or the modified part of the coded bit-stream Cₘ. In a variant, the device comprises a plurality of decoders 405 decoders 405, for simultaneously processing the original bit-stream and a plurality of modified bit-streams. The resulting sets of decoding variable states {L, R} and {Lₘ, Rₘ} and the resulting sets of decoded syntax elements {EI}, {EIₘ} are stored in the data memory 402. In a variant, the resulting decoding data may be stored locally in the decoder 405. The data memory may further store bit-streams Cₘ, Cₒ. According to a particular embodiment, the processor 401 comprises means for decoding the bit-stream, an additional decoder 405 is thus no longer needed. According to a particular embodiment, the processor 401 comprises means for modifying the bit-stream. According to a particular embodiment, the processor 401 further comprises means for performing verification steps by comparing decoded elements and state variables stored in the RAM or in the decoder. Resulting from the verification steps, the alternative element as well as the associated modified bit-stream may also be stored in the data memory for latter use by a watermarking embedder. Thus the device is adapted to implement first and second embodiments of the method previously described.

Naturally, the invention is not limited to the embodiments previously described.

In particular, the invention is neither limited to the selection of modifiable elements in VC1 nor to the selection of bypass mode syntax elements in CABAC. The invention is compatible with any type of elements. In this variant, context variables in addition to decoding variable states are used.

Besides, the method of searching some alternative parts of coded bit-stream to modify a precise part of the decoding could be generalized to every element (known for instance in CAVLC, VC1 standard) and to all other compressed contents (such as MPEG-2 bit-stream, MPEG-4 bit-stream) including compressed audio content, compressed 3D data.

Finally, the method for determining a modifiable element in a coded bit-stream is not limited to watermarking application. The invention is compliant with any others applications, involving modifying an element in a coded bit-stream while complying with the original coded bit-stream according to the coding standard.

## Claims

1. Method for determining a modifiable element in a coded bit-stream (Cₒ) **characterized in that** the method comprises:
- a step of decoding (E200) a part of the coded bit-stream (Cₒ);
- a step of modifying (E201) said part of the coded bit-stream (Cₒ);
- a step of decoding (E202) the modified part of the coded bit-stream (Cₘ);
- a step of verifying (E203) whether the modified part of the coded bit-stream (Cₘ) is compliant with the coded bit-stream (Cₒ);
- a step of verifying (E203) whether an element in the decoded modified bit-stream, called modifiable element, is different from an element in the decoded original bit-stream.

2. Method according to claim 1 **characterized in that**:
- the step of decoding (E200) said part of the bit-stream result in a first set of decoded elements ({EI});
- the step of decoding (E202) said modified part of the coded bit-stream result in a second set of decoded elements ({EIₘ}); and **in that**
- the step of verifying (E203) whether an element in the modified bit-stream, called modifiable element, is different from an element in the bit-stream comprises verifying whether the last decoded element, called modifiable element, among the second set of decoded elements is different from the last decoded element among the first set of decoded elements and whether other decoded elements among the second set of decoded elements and other decoded elements among the first set of decoded elements are identical.

3. Method according to any of claims 1 to 2 **characterized in that**:
- the step of decoding (E200) said part of the bit-stream result in a first set of decoding variable states ({L,R});
- the step of decoding (E202) said modified part of the coded bit-stream result in a second set of decoding variable states ({Lₘ, Rₘ}); and **in that**
- the step of verifying (E203) whether the modified part of the bit-stream is compliant with the bit-stream comprising verifying whether the last decoding variable states among the second set of decoding variable states ({Lₘ, Rₘ}) is identical to the last decoding variable states among the first set of decoding variable states ({L,R}).

4. Method according to any of claims 1 to 3 **characterized in that** the step of modifying (E201) said part of the coded bit-stream (Cₒ) further comprises determining a value among all possible binary values of same length as the length of the part of the coded bit-stream.

5. Method according to claim 4, **characterized in that** the step of modifying (E201) said part of the coded bit-stream (Cₒ) further comprises determining a value among binary values comprised in a range around the binary value of the part coded bit-stream.

6. Method according to claim 4, **characterized in that** the step of modifying (E201) said part of the coded bit-stream (Cₒ) further comprises determining a value among values comprised in a table.

7. Method according to any of claims 1 to 5 **characterized in that** the bit-stream is a CABAC coded bit-stream and **in that** the decoded element is a syntax element.

8. Method according to any of claims 1 to 4 and 6 **characterized in that** the bit-stream is a CAVLC coded bit-stream and **in that** the decoded element is a syntax element.

9. Method according to any of claims 1 to 8 **characterized in that**:
- the step of decoding (E202) the modified part of the coded bit-stream (Cₘ);
- the step of verifying (E203) whether the modified part of the coded bit-stream (Cₘ) is compliant with the coded bit-stream (Cₒ);
- the step of verifying (E203) whether an element in the decoded modified bit-stream, called modifiable element, is different from an element in the decoded original bit-stream.
are iteratively repeated for each modified part of the coded bit-stream resulting from the step of modifying (E201) the part of the coded bit-stream (Cₒ).

10. Device for determining a modifiable element in a coded bit-stream (Cₒ) **characterized in that** the device comprises:
- means for decoding (401, 405) a part of the coded bit-stream (Cₒ);
- means for modifying (401, 405) said part of the coded bit-stream (Cₒ);
- means for decoding (401, 405) the modified part of the coded bit-stream (Cₘ);
- means for verifying (401, 405) whether the modified part of the coded bit-stream (Cₘ) is compliant with the coded bit-stream (Cₒ);
- means for verifying (401, 405) whether an element in the decoded modified bit-stream, called modifiable element, is different from an element in the decoded original bit-stream.

11. Device according to claim 10 **characterized in that**:
- means for decoding (401, 405) said part of the bit-stream generates a first set of decoded elements ({EI});
- means for decoding (401, 405) said modified part of the coded bit-stream generates a second set of decoded elements ({EIₘ}); and **in that**
- means for verifying (401, 405) whether an element in the modified bit-stream, called modifiable element, is different from an element in the bit-stream comprises means for verifying whether the last decoded element, called modifiable element, among the second set of decoded elements is different from the last decoded element among the first set of decoded elements and whether other decoded elements among the second set of decoded elements and other decoded elements among the first set of decoded elements are identical.

12. Device according to any of claims 10 to 11 **characterized in that**:
- means for decoding (401, 405) said part of the bit-stream generates a first set of decoding variable states ({L,R});
- means for decoding (401, 405) said modified part of the coded bit-stream generates a second set of decoding variable states ({Lₘ, Rₘ}); and **in that**
- means for verifying (401, 405) whether the modified part of the bit-stream is compliant with the bit-stream comprising means for verifying whether the last decoding variable states among the second set of modified decoding variable states ({Lₘ, Rₘ}) is identical to the last decoding variable states among the first set of decoding variable states ({L,R}).

13. Device according to any of claims 10 to 12 **characterized in that** the bit-stream is a CABAC coded bit-stream and **in that** the decoded element is a syntax element.

14. Device according to any of claims 10 to 12 **characterized in that** the bit-stream is a CAVLC coded bit-stream and **in that** the decoded element is a syntax element.

15. Device according to any of claims 10 to 14 **characterized in that** the modifiable element is adapted to carry watermark.
